(19)

Europäisches
Patentamt
European
Patent Office
Office européen
des brevets

(11) **EP 2 197 041 A1**

(12) **EUROPEAN PATENT APPLICATION**
published in accordance with Art. 153(4) EPC

(43) Date of publication:
**16.06.2010 Bulletin 2010/24**

(21) Application number: **08833691.2**

(22) Date of filing: **26.09.2008**

(51) Int Cl.:
***H01L 31/052*** *(2006.01)*

(86) International application number:
**PCT/JP2008/067400**

(87) International publication number:
**WO 2009/041561 (02.04.2009 Gazette 2009/14)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **26.09.2007 JP 2007249962**

(71) Applicants:
• **Toyo Tanso Co., Ltd.**
**Osaka-shi**
**Osaka 555-0011 (JP)**
• **Institute of National Colleges of Technology, Japan**
**Hachioji-shi, Tokyo 193-0834 (JP)**

(72) Inventors:
• **HIROSE, Yoshiaki**
**Mitoyo-shi**
**Kagawa 769-1102 (JP)**
• **YUKI, Tetsuya**
**Mitoyo-shi**
**Kagawa 769-1102 (JP)**
• **MISAKI, Yukinori**
**Mitoyo-shi**
**Kagawa 769-1192 (JP)**
• **KOMIYA, Hitomi**
**Marugame-shi**
**Kagawa 763-0054 (JP)**

(74) Representative: **Glawe, Delfs, Moll**
**Patent- und Rechtsanwälte**
**Postfach 26 01 62**
**80058 München (DE)**

(54) **SOLAR CELL UNIT**

(57) A solar battery unit is provided that can release the heat of the solar battery module sufficiently and suppress the temperature increase of a solar battery module by inhibiting the presence of an air layer with a low thermal conductivity in a heat transfer passage, whereby the energy conversion efficiency can be improved remarkably. A solar battery unit has: a solar battery module (2); and a heat dissipating member (4), provided on a back surface of the solar battery module (2), for releasing heat from the solar battery module (2). A heat transfer sheet (3) including expanded graphite is interposed between the solar battery module (2) and the heat dissipating member (4), and the heat transfer sheet (3) is attached in a compressed state to the solar battery module (2) and the heat dissipating member (4).

Fig. 2

EP 2 197 041 A1

**Description**

TECHNICAL FIELD

The present invention relates to a solar battery panel having a solar battery module that generates electricity from sunlight, and more particularly to a solar battery unit that can improve energy conversion efficiency.

BACKGROUND ART

The electric power generated by a solar battery module increases according to the amount of solar radiation. However, when the temperature of the solar battery module increases, the energy conversion efficiency decreases in proportion to the temperature increase. For this reason, a problem with the solar battery module has been that the solar battery module cannot obtain the maximum electric power in summer, the season in which the amount of solar radiation is greatest, because of the temperature increase of the solar battery module. In view of this problem, the following solar battery units have been proposed.
(1) A solar battery unit has a solar battery module in which a plurality of solar battery cells are laid over a glass substrate and integrated with one another, a flame-like holder for retaining the solar battery module, and a plurality of cooling fins made of aluminum and affixed to the back surface of the solar battery module. The holder has a plurality of vents so that air can flow to the cooling fins (see the following Patent Document 1).
(2) A solar battery unit has a solar battery module and a holder for retaining the solar battery module made of an aluminum alloy, and the holder has a plurality of coolant passages for the coolant that cools the solar battery module (see the following Patent Document 2).

[Patent Document 1] Japanese Published Unexamined Patent Application No. H09-83003

[Patent Document 2] Japanese Published Unexamined Patent Application No. 2000-114574

DISCLOSURE OF THE INVENTION

PROBLEMS TO BE SOLVED BY THE INVENTION

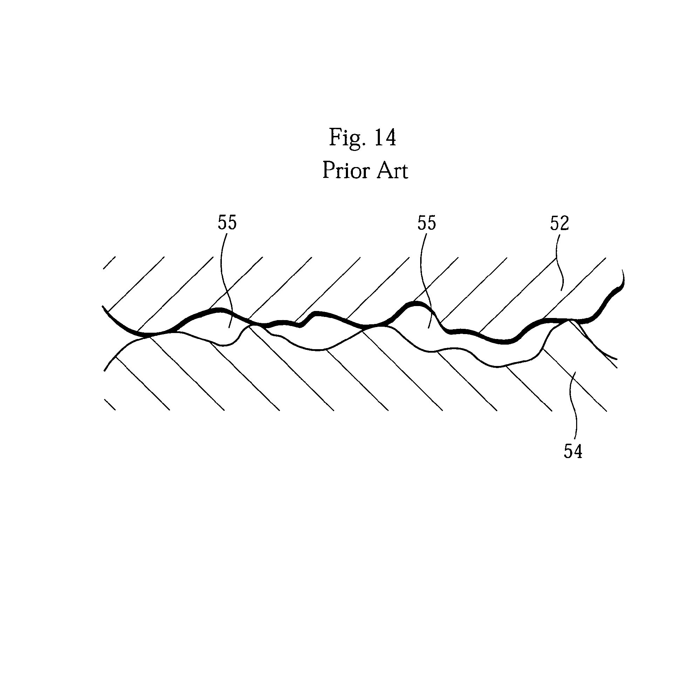

It may appear that the cooling fins as shown in the foregoing (1) and the holder provided with the coolant passages as shown in the foregoing (2) can release heat of the solar battery module sufficiently because they are made of aluminum or an aluminum alloy, which has high thermal conductivity. However, in reality, the heat of the solar battery module cannot be released sufficiently with the inventions described in the foregoing (1) and (2). The reason is as follows. In the surface of the holder and the cooling fin (heat dissipating member) made of aluminum and the like, there exist very small surface irregularities, and microscopically, the solar battery module and the heat dissipating member are not in close contact with each other. This means that an air layer 55, which has low thermal conductivity, [thermal conductivity of air: 0.0241 W/(m·K)] exists between a solar battery module 52 and a heat dissipating member 54, as shown in Fig. 14. Consequently, even if aluminum, copper, or the like, which has high thermal conductivity, is used for the heat dissipating member 54, the heat of the solar battery module 52 cannot be released sufficiently because of the presence of the air layer 55, and the energy conversion efficiency is lowered.
In view of the foregoing circumstances, it is an object of the present invention to provide a solar battery unit that can release the heat of the solar battery module sufficiently and suppress the temperature increase of the solar battery module by inhibiting the presence of an air layer with a low thermal conductivity in a heat transfer passage, whereby the energy conversion efficiency can be improved remarkably.

MEANS FOR SOLVING THE PROBLEMS

In order to accomplish the foregoing object, the present invention provides a solar battery unit comprising: a solar battery module; and a heat dissipating means, provided on a back surface of the solar battery module, for releasing heat from the solar battery module, the solar battery unit being **characterized in that** a heat transfer sheet comprising expanded graphite is interposed between the solar battery module and the heat dissipating means, and the heat transfer sheet is attached in a compressed state to the solar battery module and the heat dissipating means.

When the heat transfer sheet is interposed between the solar battery module and the heat dissipating means as in the above-described configuration, the heat from the solar battery module can be transferred to the heat dissipating means through the heat transfer sheet. In this case, the heat transfer sheet comprising expanded graphite is capable of deforming because it is in a compressed state. As a result, the adhesion between the heat transfer sheet and the solar battery module and between the heat transfer sheet and the heat dissipating means improves, preventing the presence of an air layer, which has low thermal conductivity, between the solar battery module and the heat dissipating means. Thus, the heat of the solar battery module can be transmitted sufficiently to the heat dissipating means, so the temperature increase of the solar battery module is suppressed. As a result, the energy conversion efficiency of the solar battery unit can be improved remarkably.

It is desirable that he heat dissipating means be in a plate shape, and the heat transfer sheet be sandwiched between the heat dissipating means and the back surface of the solar battery module.

With the above-described configuration, the adhesion of the heat transfer sheet with the solar battery module and the heat dissipating means increases because of the self weight of the solar battery module. Accordingly, the above-described advantageous effects can be obtained with a simple method.

It is desirable that a cooling fin be formed on a surface of the heat dissipating means that is opposite a surface thereof being in contact with the heat transfer sheet.

The just-described configuration can further improve the cooling efficiency of the solar battery unit because of the presence of the cooling fin formed on the heat dissipating means.

It is desirable that a coolant passage for passing coolant be provided in the heat dissipating means.

The just-described configuration makes it possible to further improve the cooling efficiency of the solar battery unit because of the presence of the coolant flowing through the coolant passage.

The invention also provides a solar battery unit comprising: a solar battery module; and a heat dissipating means, provided on a back surface of the solar battery module, for releasing heat from the solar battery module, the solar battery unit being **characterized in that** the heat dissipating means comprises a heat transfer sheet comprising expanded graphite, and the heat transfer sheet is attached in a compressed state to the solar battery module.

It is not essential to provide a heat dissipating means separately as described above, but it is also possible to employ a configuration in which the heat transfer sheet comprising expanded graphite also serves as the heat dissipating means. The reason is that the heat transfer sheet has a small heat capacity so that it can dissipate heat by radiation. With such a configuration, the weight of the solar battery unit itself can be reduced because the heat transfer sheet comprising expanded graphite is much lighter in weight than a heat dissipating means made of, for example, aluminum. As a result, workability in shipping and installing of the solar battery unit is improved, and moreover, the cost of the solar battery unit can be reduced because the parts count of the solar battery unit reduces.

It should be noted that an air layer exists between the heat transfer sheet and the solar battery module unless the heat transfer sheet is attached in a compressed state to the solar battery module. For this reason, it is necessary that the heat transfer sheet be attached in a compressed state to the solar battery module or affixed by an adhesive agent, a tackiness agent, or the like.

It is desirable that the pressure to the heat transfer sheet be from 0.5 MPa to 10.0 MPa.

The reason is as follows. If the pressure to the heat transfer sheet is less than 0.5 MPa, the deformation of the heat transfer sheet is insufficient, so the adhesion of the heat transfer sheet with the solar battery module or with the heat transfer sheet becomes insufficient. Consequently, the presence of an air layer with a low thermal conductivity may not be prevented between the solar battery module and the heat dissipating means. As a consequence, the energy conversion efficiency of the solar battery unit may not be improved sufficiently. On the other hand, if the pressure exceeds 10.0 MPa, the solar battery module may be damaged.

It is desirable that the heat transfer sheet have a bulk density of 1.0 Mg/m$^3$ or lower.

The reason is as follows. If the bulk density of the heat transfer sheet exceeds 1.0 Mg/m$^3$, the flexibility of the heat transfer sheet lowers, although the thermal conductivity and strength of the heat transfer sheet increase. As a consequence, the adhesion of the heat transfer sheet with the solar battery module or with the heat dissipating means may become poor, and the cooling efficiency of the solar battery module may decrease.

The invention also provides a solar battery unit comprising: a solar battery module; and a heat dissipating means, provided on a back surface of the solar battery module, for releasing heat from the solar battery module, the solar battery unit being **characterized in that** the heat dissipating means comprises a heat transfer sheet comprising expanded graphite, and the heat transfer sheet is affixed to the solar battery module.

With such a configuration, heat dissipation by the heat transfer sheet is made possible by merely affixing the heat transfer sheet to the solar battery module, and moreover, the weight of the solar battery unit itself can be reduced. An adhesive agent or a tackiness agent may be used when affixing the heat transfer sheet and the solar battery module to each other. However, if the viscosity of the agent is too high, the surface irregularities of the solar battery module cannot be filled, and an air layer may form between the solar battery module and the heat transfer sheet. For this reason, it is desirable that the viscosity of the adhesive agent or the tackiness agent be 1000 Pa•s or less. If the thermal conductivity of the adhesive agent or the tackiness agent is too low, the heat dissipation capability may be insufficient. For this reason, it is desirable that the thermal conductivity of the adhesive agent or the tackiness agent be 0.5 W/(m•K) or higher.

It is desirable that the just-described heat transfer sheet have a bulk density of from 1.0 Mg/m$^3$ to 2.0 Mg/m$^3$. The reason is as follows. If the bulk density of the heat transfer sheet is less than 1.0 Mg/m$^3$, the thermal conductivity of the heat transfer sheet is so low that the cooling efficiency of the solar battery module may be too low, or the strength of the heat transfer sheet is so poor that the workability in fitting the heat transfer sheet may be too poor. On the other hand, if the bulk density of the heat transfer sheet exceeds 2.0 Mg/m$^3$, the flexibility of the heat transfer sheet may become poor.

It is desirable that the heat transfer sheet have a thickness of from 0.1 mm to 3.0 mm. The reason is as follows. If the thickness of the heat transfer sheet exceeds 3.0 mm, the heat transfer capability of the heat transfer sheet will be low, although the strength of the heat transfer sheet will be high. As a consequence, the cooling efficiency of the solar battery module may become poor. On the other hand, if the thickness of the heat transfer sheet is less than 0.1 mm, the strength of the heat transfer sheet may become poor, although the heat transfer capability of the heat transfer sheet will be high. As a consequence, the workability in fitting the heat transfer sheet may become poor.

ADVANTAGES OF THE INVENTION

As discussed above, the present invention exhibits a significant advantage of improving the energy conversion efficiency of a solar battery unit remarkably because the heat of the solar battery module can be released sufficiently and the temperature increase of the solar battery module can be suppressed by inhibiting the presence of an air layer with a low thermal conductivity in a heat transfer passage.

BEST MODE FOR CARRYING OUT THE INVENTION

Next, embodiments of the present invention will be described with reference to the drawings. A heat transfer sheet of the present invention is used for cooling a solar battery module, which is a heat generating body, and it is **characterized in that** the thermal resistance is reduced and the heat transfer capability is improved by generally employing one of the following configurations.

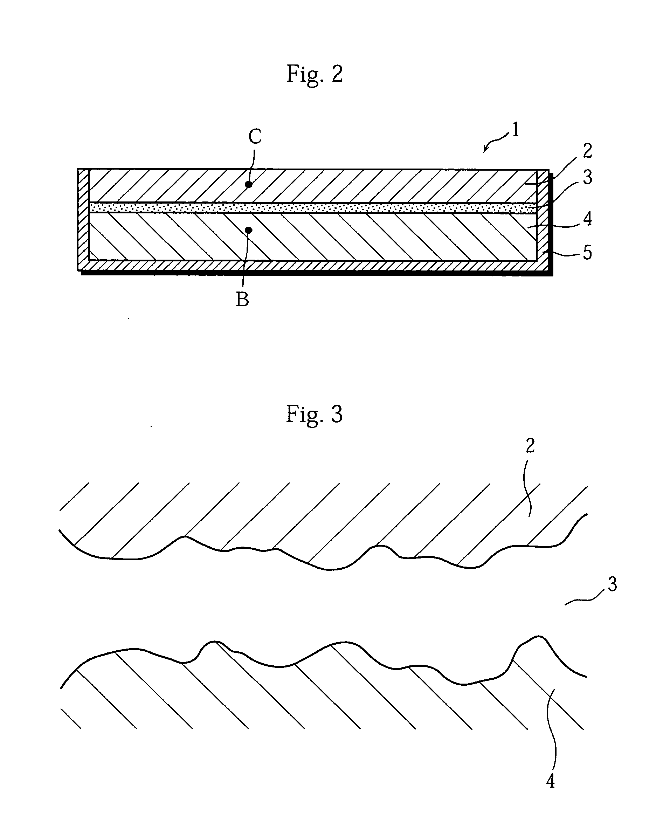

(1) The heat transfer sheet is disposed in a compressed state between the solar battery module and a heat dissipating member (heat dissipating means) such as a heat sink.
(2) The heat transfer sheet that serves as a heat dissipating member is affixed to the back surface of the solar battery module.
(3) The heat transfer sheet that serves as a heat dissipating member is disposed on the back surface of the solar battery module in a compressed state.
The thermal resistance is the value obtained by dividing the temperature difference between two distant points in a member that is supplied with heat from a heat generating body by the amount of the heat generated by the heat generating body. With reference to Fig. 2, it is the value obtained by dividing the value obtained by subtracting the temperature at point C from the temperature at point B, in other words, the temperature difference between point B and point C, by the amount of the heat generated by the heat generating body (i.e., a solar battery module 2).

Here, the details of the configuration of each of the solar battery units shown in the foregoing (1) to (3) will be described.

The Configuration of the Solar Battery Unit Shown in (1)

The heat transfer sheet used for the solar battery unit of this configuration is made of expanded graphite formed into a sheet shape, the expanded graphite formed by immersing natural graphite, kish graphite, or the like in a liquid such as sulfuric acid and nitric acid and thereafter heat-treated at 400°C or higher. The thickness of The heat transfer sheet is formed so as to have a thickness of from 0.1 mm to 3.0 mm and a bulk density of 0.3 Mg/m$^3$ to 1.0 Mg/m$^3$. The expanded graphite is in a caterpillar-like form or in a fibrous form, in other words, one in which its axial length is longer than its radial length. For example, the axial length may be about 1 mm and the radial length may be about 300 μm. Filaments of the expanded graphite fiber as described above are entangled with one another inside the heat transfer sheet of the present invention.

The heat transfer sheet of the present invention may be formed of expanded graphite alone as described above, but it is possible that a binder such as a phenolic resin or a rubber component may be contained therein in a small amount (for example, about 5%). Moreover, the method of forming the heat transfer sheet of the present invention from expanded graphite as described above is not particularly limited.

Here, the purpose of the present invention is accomplished by interposing the heat transfer sheet between the solar battery module and the heat dissipating member such as a heat sink. However, it is believed that the purpose of the present invention is more accomplished by restricting the bulk density of the heat transfer sheet. Accordingly, discussion is now made from the viewpoint of the bulk density of the heat transfer sheet.

An expanded graphite sheet formed of expanded graphite shows higher thermal conductivity in a plane direction but lower flexibility when its bulk density increases. For this reason, the bulk density of the expanded graphite sheet is adjusted according to its uses. Usually, the one used as a heat transfer sheet is constructed to have a high bulk density (for example, 1.3 $Mg/m^3$ or higher) because the heat conduction capability is viewed as important. On the other hand, the one used as a wall heat insulating material or an electro-magnetic wave shielding material is constructed to have a low bulk density (for example, 1.0 $Mg/m^3$ or lower).

Considering the case that an expanded graphite sheet is used for the heat transfer sheet of the present invention, it is desirable that the expanded graphite sheet be constructed while viewing the flexibility as important and also taking the heat conduction capability into consideration. The reason is as follows. If the heat transfer sheet lacks heat conduction capability, the heat transfer sheet cannot exhibit its intrinsic function sufficiently, so the heat of the solar battery module cannot be transmitted to the heat dissipating member sufficiently. On the other hand, if the heat transfer sheet lacks flexibility, it cannot prevent the presence of the air layer with low thermal conductivity in the heat transfer passage, so likewise the heat of the solar battery module cannot be transmitted to the heat dissipating member sufficiently.

It should be noted that the flexibility is viewed more important than the heat conduction capability for the following reason. If the bulk density of the expanded graphite sheet is not very low (i.e., not less than 0.3 $Mg/m^3$), the thermal conductivity across the thickness becomes 5 $W/(m \cdot K)$ or higher, so the purpose of the present invention can be met sufficiently. On the other hand, so if an air layer is present in the heat transfer passage, heat transmission will be hindered considerably since the thermal conductivity of the air is extremely low [0.0241 $W/(m \cdot K)$], so the purpose of the present invention cannot be met.

Taking the above discussion into consideration, sufficient flexibility of the heat transfer sheet is ensured and thereby the ability to even out surface irregularities is imparted to the heat transfer sheet by restricting the bulk density of the heat transfer sheet to be 1.0 $Mg/m^3$ or lower (desirably 0.9 $Mg/m^3$ or lower, and particularly desirably 0.8 $Mg/m^3$ or lower), so that it is possible to prevent an air layer from existing in the heat transfer passage.
Nevertheless, if the bulk density of the heat transfer sheet is less than 0.3 $Mg/m^3$, the thermal conductivity of the heat transfer sheet in a plane direction will be so low that the cooling efficiency of the solar battery module may become too low, or the strength of the heat transfer sheet will be so poor that the workability in fitting the heat transfer sheet may become too poor, although the heat transfer sheet shows high flexibility.
For this reason, it is desirable that the bulk density of the heat transfer sheet be 0.3 $Mg/m^3$ or higher.

Next, discussion is made from the viewpoint of the pressure to the heat transfer sheet. It is desirable that the pressure to the heat transfer sheet be from 0.3 MPa to 10.0 MPa.
The reason is as follows. If the pressure to the heat transfer sheet is less than 0.3 MPa, the deformation of the heat transfer sheet is insufficient, so the adhesion between the heat transfer sheet and the solar battery module or between the heat transfer sheet and the heat dissipating member cannot be improved sufficiently, and the presence of an air layer with a low thermal conductivity cannot be prevented in the heat transfer passage. As a consequence, the energy conversion efficiency of the solar battery unit may not be improved sufficiently. On the other hand, if the pressure exceeds 10.0 MPa, the solar battery module may be damaged.

Further, discussion is now made from the viewpoint of the thickness of the heat transfer sheet. It is desirable that the heat transfer sheet have a thickness of from 0.1 mm to 3.0 mm.
The reason is as follows. If the thickness of the heat transfer sheet exceeds 3.0 mm, the heat transfer capability of the heat transfer sheet will be low, although the strength of the heat transfer sheet will be high. As a consequence, the cooling efficiency of the solar battery module may become poor. On the other hand, if the thickness of the heat transfer sheet is less than 0.1 mm, the strength of the heat transfer sheet may become poor, although the heat transfer capability of the heat transfer sheet will be high. As a consequence, the workability in fitting the heat transfer sheet may become poor.

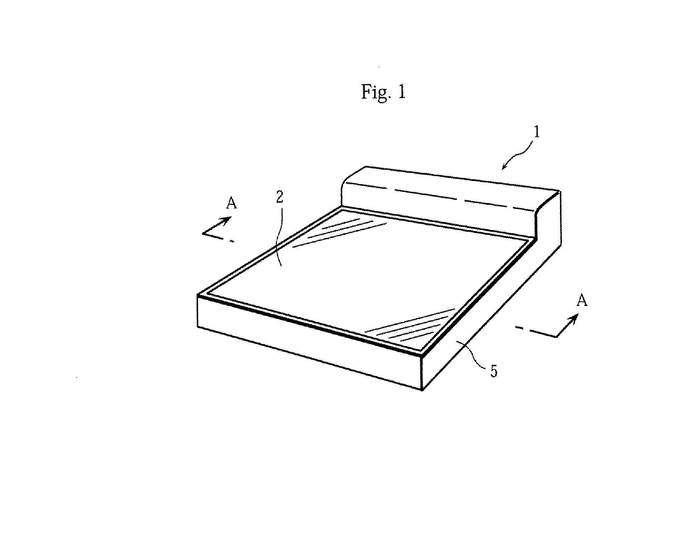

Next, the configuration of the solar battery unit shown in (1) will be described below with reference to Figs. 1 to 3. Fig. 1 is a perspective view of the solar battery unit, Fig. 2 is a cross-sectional view taken along line A-A in Fig. 1, and Fig. 3 is an enlarged cross-sectional view illustrating a portion in the vicinity of an interface. In Figs. 1 to 3, reference numeral 1 denotes a solar battery unit, reference numeral 2 denotes a solar battery module, reference numeral 3 denotes a heat transfer sheet, and reference numeral 4 denotes a heat dissipating member, and reference numeral 5 denotes a frame.

As illustrated in Figs. 1 and 2, the heat transfer sheet 3 is disposed so as to be sandwiched between the solar battery module 2 and the heat dissipating member 4. This means that the heat transfer sheet 3 is compressed by the self weight of the solar battery module 2 in such a state as to be sandwiched between the solar battery module 2 and the heat dissipating member 4. In such a state, the thickness of the heat transfer sheet 3 becomes less, and the less the thickness of the heat transfer sheet 3 becomes, the more the adhesion of the heat transfer sheet 3 with the solar battery module 2 and with the heat dissipating member 4. The reason is that since space exists between the filaments of the expanded graphite that forms the heat transfer sheet 3, the expanded graphite located in the surface of the heat transfer sheet 3 enters the interior of the irregularities existing in the surface of the solar battery module 2 and the surface of the heat dissipating member 4 during the process in which the heat transfer sheet is compressed. Such a phenomenon is noticeable when the heat transfer sheet 3 has a bulk density of 1.0 Mg/m$^3$ or lower, in which the space between the filaments of the expanded graphite is large.

When the above-described condition is reached, an air layer is prevented from forming between the solar battery module 2 and the heat transfer sheet 3 and between the heat transfer sheet 3 and the heat dissipating member 4, as illustrated in Fig. 3, so the thermal resistance in the heat transfer passage decreases remarkably. As a result, the cooling efficiency of the solar battery module 2 is increased and the temperature increase of the solar battery module 2 is suppressed. Therefore, the energy conversion efficiency of the solar battery module 2 can be improved remarkably.

In the above-described configuration, the heat transfer sheet 3 is merely sandwiched between the solar battery module 2 and the heat dissipating member 4, so the heat transfer sheet 3 can be easily replaced when it becomes necessary to replace the heat transfer sheet 3.

In addition, because the heat transfer sheet 3 prepared in the above-described manner has a thermal conductivity in a plane direction of about 50 to 200 W/(m•K), which is significantly higher than the thermal conductivity across the thickness, the temperature distribution of the heat transfer sheet 3 in a plane direction can be kept substantially uniform. As a result, it becomes possible to prevent heat spots from forming in the heat transfer sheet 3 and the solar battery module 2 as well as the heat dissipating member 4.

Moreover, the heat transfer sheet 3 and the heat dissipating member 4 do not need to be separate as long as the heat transfer sheet 3 can be disposed in such a state as to be sandwiched between the solar battery module 2 and the heat dissipating member 4. For example, the heat transfer sheet 3 may be affixed to the heat dissipating member 4 by an adhesive agent or the like.

The Configuration of the Solar Battery Unit Shown in (2)

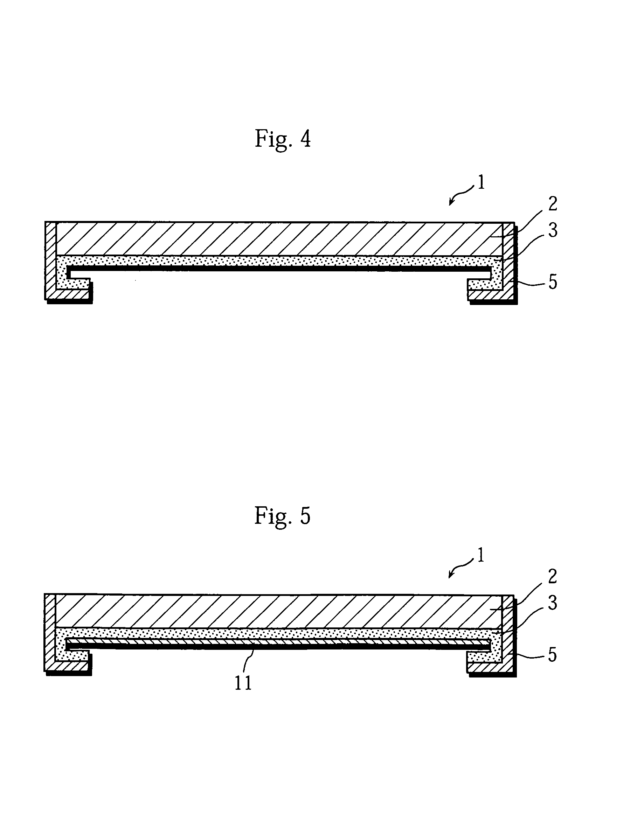

The heat dissipating member 4 used in the solar battery unit described in the foregoing (1) is not essential, and it is possible to employ the configuration in which, as illustrated in Fig. 4, the heat transfer sheet 3 (which exhibits the function as a heat dissipating member in this case) is affixed to the back surface of the solar battery module 2 by an adhesive agent and both ends of the heat transfer sheet 3 are affixed to the frame 5. With this configuration, heat is released to the air by the radiation from the heat transfer sheet 3, and at the same time, heat is transferred from the heat transfer sheet 3 to the frame 5, so that heat is released also from the frame 5. It should be noted that the heat transfer sheet 3 can be manufactured in the same method as that shown in the section that has described the configuration of the solar battery unit shown in the foregoing (1).

Here, it is desirable that the adhesive agent or the tackiness agent have a viscosity of 1000Pa•s or less. The reason is that if the viscosity of the adhesive agent exceeds 1000Pa•s, the surface irregularities of the solar battery module 2 cannot be filled with an adhesive agent or a tackiness agent and an air layer may form between the solar battery module 2 and the heat transfer sheet 3. In addition, in order to inhibit the heat transfer capability of the adhesive agent layer or the tackiness agent layer from deteriorating, it is desirable that the thermal conductivity thereof be 0.5 W/(m•K) or higher. Examples of such an adhesive agent or tackiness agent include a silicone grease and an epoxy resin.

In addition, it is desirable that the heat transfer sheet 3 have a bulk density of from 1.0 Mg/m$^3$ to 2.0 Mg/m$^3$. The reason is as follows. If the bulk density of the heat transfer sheet 3 is less than 1.0 Mg/m$^3$, the thermal conductivity of the heat transfer sheet 3 will be so low that the cooling efficiency of the solar battery module 2 may be too low, or the strength of the heat transfer sheet 3 will be so poor that the workability in fitting the heat transfer sheet may be too poor. On the other hand, if the bulk density of the heat transfer sheet exceeds 2.0 Mg/m$^3$, the flexibility of the heat transfer sheet may become poor.

Further, from the viewpoint of the thickness of the heat transfer sheet 3, it is desirable that the heat transfer sheet 3 have a thickness of from 0.1 mm to 3.0 mm. The reason is the same as described in the section that has described the configuration of the solar battery unit shown in the foregoing (1).

It should be noted that both ends of the heat transfer sheet 3 do not necessarily have such a configuration as to be affixed to the frame 5, but they need not be affixed to the frame 5. For example, it is also possible to employ a configuration in which the heat transfer sheet 3 has the same width and length as those of the solar battery module 2 and the heat transfer sheet 3 may exist only on the back surface of the solar battery module 2. That said, with such a configuration, heat cannot be released from the frame 5, so it is preferable to employ the configuration in which both ends of the heat transfer sheet 3 are affixed to the frame 5.

The Configuration of the Solar Battery Unit Shown in (3)

A solar battery unit is configured to have the same configuration as described in the foregoing (2) except that, as illustrated in Fig. 5, the heat transfer sheet 3 is not affixed to the solar battery module 2 but is compressed against the solar battery module 2 by a pressing member 11 disposed on the back surface of the heat transfer sheet 3. Since the pressing member 11 does not function as the heat dissipating member 4, it does not need to have a high thermal conductivity. However, to prevent deformation caused by heat, it is desirable that it have a heat resistance of about 100°C. It should be noted that the heat transfer sheet 3 can be manufactured in the same method as that shown in the section that has described the configuration of the solar battery unit shown in the foregoing (1).

It is desirable that the heat transfer sheet 3 have a bulk density of from 0.3 $Mg/m^3$ to 1.0 $Mg/m^3$ (desirably 0.9 $Mg/m^3$ or lower, particularly desirably 0.8 $Mg/m^3$ or lower). In addition, it is desirable that the pressure to the heat transfer sheet 3 be from 0.5 MPa to 10.0 MPa, and further, it is desirable that the heat transfer sheet 3 has a thickness of from 0.1 mm to 3.0 mm. The reason is the same as described in the section that has described the configuration of the solar battery unit shown in the foregoing (1).

(Other Embodiments)

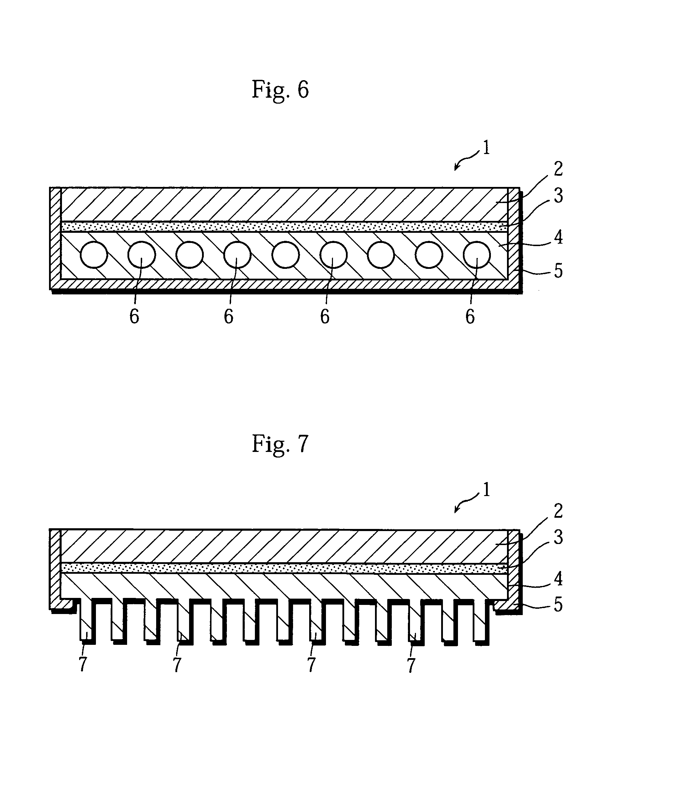

(1) The heat dissipating member 4 is not limited to that described above. It may have a structure in which coolant passages 6 ... for passing coolant such as water are provided in a main unit 4b, as illustrated in Fig. 6. It may also have a structure in which cooling fins 7 ... are formed on a surface of the main unit 4b that is opposite the surface being in contact with the heat transfer sheet 3, as illustrated in Fig. 7. With these structures, the cooling efficiency of the solar battery module 2 can be increased further because of the presence of the cooling fins 7 ... or the coolant flowing in the coolant passages 6 ..., and therefore, the energy conversion efficiency of the solar battery module 2 can be improved further.

(2) Generally, the heat transfer sheet 3 is rarely recycled. However, when recycling is taken into consideration, it is desirable to make the following restrictions.

When compressing the heat transfer sheet 3, it is desirable that the heat transfer sheet 3 be adjusted so that the compression ratio represented by the following equation (1) will be 50% or greater and the recovery ratio represented by the following equation (2) will be 5% or greater. With such a configuration, even when the heat transfer sheet 3 is compressed a plurality of times, the bulk density thereof after the pressure is removed is kept at less than 1.0 $Mg/m^3$. Therefore, when the heat transfer sheet 3 is compressed in such a state as to be sandwiched between the solar battery module 2 and the heat dissipating member 4, the adhesion of the heat transfer sheet 3 with the solar battery module 2 and the heat dissipating member 4 can be kept high even after the heat transfer sheet 3 has been used a plurality of times. As a result, the thermal resistance can be kept small even after the heat transfer sheet 3 has been used a plurality of times. Thus, recyclability can be improved.

$$\text{Compression ratio (\%)} = [(t_1 - t_2)/t_1] \times 100 \qquad (1)$$

In the above equation (1), $t_1$ is the thickness (mm) of the heat transfer sheet after applying a pre-load (0.686 MPa$\pm$1%) for 15 seconds, and $t_2$ is the thickness (mm) of the heat transfer sheet after applying a total pressure (34.3 MPa$\pm$1%) for 60 seconds.

$$\text{Recovery ratio (\%)} = [(t_3 - t_2) / (t_1 - t_2)] \times 100 \qquad (2)$$

In the above equation (2), $t_1$ is the thickness (mm) after applying a pre-load (0.686 MPa$\pm$1%) for 15 seconds, $t_2$ is the thickness (mm) after applying a total pressure (34.3 MPa$\pm$1%) for 60 seconds, and $t_3$ is the thickness after resetting the pressure to the pre-load and elapsing 60 seconds.

In particular, when the heat transfer sheet is adjusted so that the compression ratio represented by the above equation (1) is 55% or greater and the recovery ratio represented by the above equation (2) is 6% or greater, the heat transfer sheet can be kept more reliably in such a state that the bulk density is less than 1.0 $Mg/m^3$, for example, less

than 0.9 Mg/m$^3$, after the pressure has been removed, so that the recyclability can be improved further.

It is undesirable that the heat transfer sheet 3 have a compression ratio of less than 50% because the adhesion with the solar battery module 2 and the heat dissipating member 4 becomes poor. It is also undesirable that the heat transfer sheet 3 have a recovery ratio of less than 5% because the adhesion with the solar battery module 2 and the heat dissipating member 4 cannot be kept high when the heat transfer sheet is recycled so the heat transfer sheet cannot cope with recycling.

In addition, if the self weight of the solar battery module 2 is too great even when the heat transfer sheet 3 has a bulk density of less than 1.0 Mg/m$^3$, the pressure applied to the heat transfer sheet 3 will be too high, so the solar battery module may be damaged (specifically, when the pressure exceeds 10.0 MPa).

By using the heat transfer sheet 3 having a bulk density of 0.9 Mg/m$^3$ or lower and restricting the pressure applied to the heat transfer sheet 3 to be 1.5 MPa or lower as described above, the bulk density of the heat transfer sheet 3 after removing the pressure can be kept at 0.9 Mg/m$^3$ or lower, the adhesion between the solar battery module 2 and the heat transfer sheet 3 and between the heat transfer sheet 3 and the heat dissipating member 4 can be improved, and moreover, the recoverability can be also maintained. As a result, the thermal resistance can be reduced by further increasing the adhesion of the heat transfer sheet 3 with the solar battery module 2 and with the heat dissipating member 4 while ensuring the recyclability of the heat transfer sheet 3.

In particular, by using the heat transfer sheet 3 having a bulk density of 0.8 Mg/m$^3$ or lower and restricting the pressure applied to the heat transfer sheet 3 to be 1.0 MPa or lower, the bulk density of the heat transfer sheet 3 after removing the pressure can be kept at 0.8 Mg/m$^3$ or lower, the adhesion of the heat transfer sheet 3 with the solar battery module 2 and with the heat dissipating member 4 can be improved, and moreover, the recoverability can be maintained.

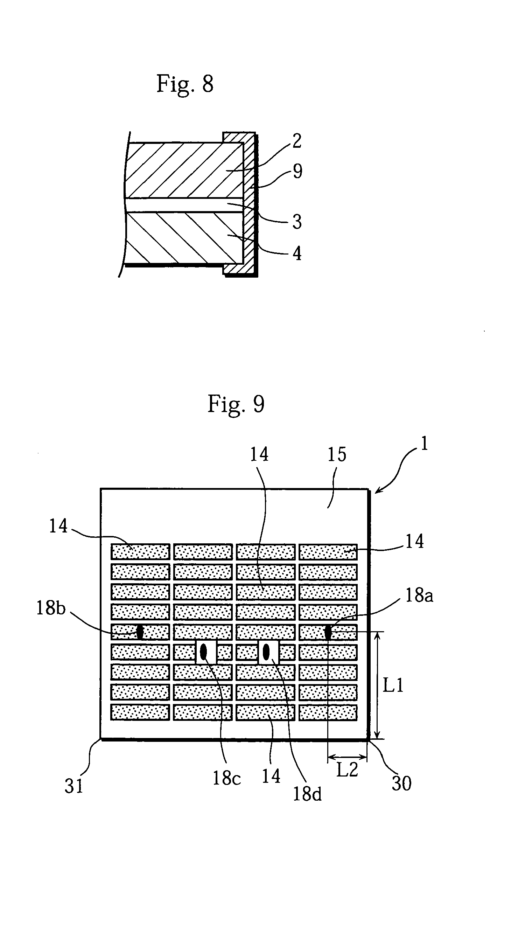

In the case that the self weight of the solar battery module 2 is low, it is possible that the pressure applied to the heat transfer sheet 3 becomes so low (specifically, when the pressure becomes less than 0.5 MPa), resulting in poor adhesion between the solar battery module 2 and the heat transfer sheet 3 and between the heat transfer sheet 3 and the heat dissipating member 4, and consequently, the thermal resistance may not be reduced sufficiently. For this reason, in such a case, it is preferable to use a clamp 9 that can sandwich the solar battery module 2, the heat transfer sheet 3, and the heat dissipating member 4, as illustrated in Fig. 8.

(3) An insulating sheet layer made of, for example, polyethylene terephthalate may be formed on the surface of the heat transfer sheet 3 in the case that insulation is necessary between the solar battery module 2 and the heat transfer sheet 3.

(4) The solar battery unit to which the heat transfer sheet 3 is attached can be prevented from deteriorating reliably when the heat transfer sheet 3 is treated so that the total amount of impurities contained, such as sulfur and iron contents, will be 10 ppm or less, in particular, the sulfur content will be 1 ppm or less.

(5) A resin film of polyethylene terephthalate or the like may be disposed between the heat transfer sheet 3 and the solar battery module 2 and/or between the heat transfer sheet 3 and the heat dissipating member 4. This configuration makes it possible to prevent the expanded graphite or the like detached from the heat transfer sheet 3 from scattering around the heat transfer sheet 3. In this case, the resin film to be used is not particularly limited as long as the resin film has almost the same thermal conductivity across the thickness as the heat transfer sheet 3 and a heat resistance of about 100°C.

EXAMPLES

(Example)

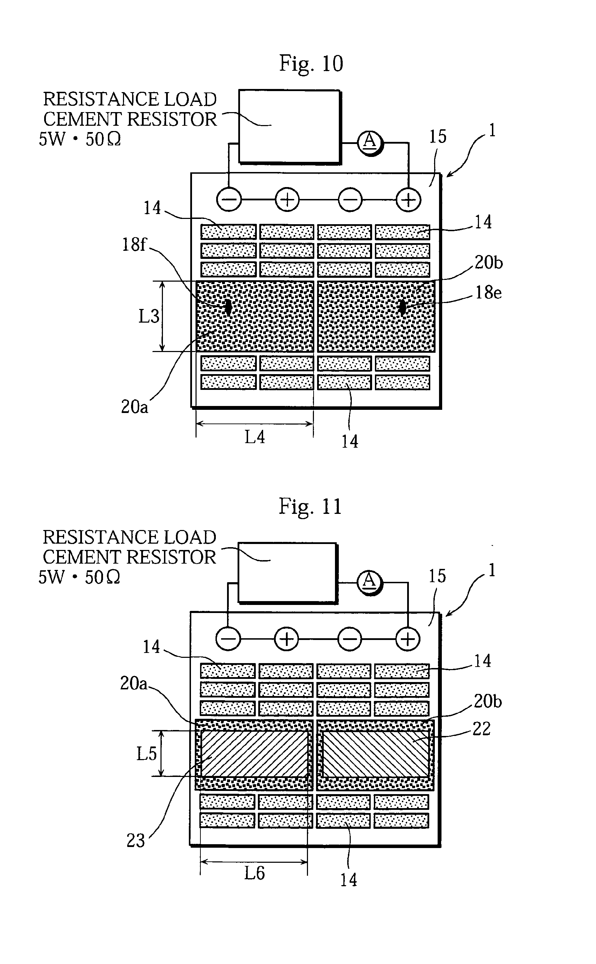

An example of the present invention will be described below with reference to Figs. 9 to 11. Fig. 9 is a front view of a solar battery module. Fig. 10 is a rear view of the solar battery module on the back surface of which a stainless steel plate is affixed.

Fig. 11 is a rear view of the solar battery module in which a heat transfer sheet made of expanded graphite or the like and an aluminum plate are affixed to the stainless steel plate affixed to the back surface thereof.

As illustrated in Fig. 9, the solar battery module 1 has a structure in which a plurality of solar battery cells 14 are arrayed uniformly between glass plates 15. Thermocouples 18a to 18d are attached to some of the solar battery cells 14. (The thermocouple 18a is disposed at a location separated from a corner 30 by a distance L1 = 100 mm and a distance L2 = 25 mm. The thermocouple 18b is disposed so that the distances from a corner 31 are the same as in the case of the thermocouple 18a.)

Two stainless steel plates (width L3 = 80 mm, length L4 = 115 mm, thickness = 0.1 mm) 20a and 20b are affixed to the back surface of the solar battery module 1 by silicone grease (viscosity 330Pa•s, thermal conductivity 0.9 W/(m•K)), which is not shown in the drawings, as illustrated in Fig. 10. Thermocouples 18e and 18f are attached at locations in the stainless steel plates 20a and 20b that correspond to the thermocouples 18a and 18b. In addition, as illustrated in Fig. 11, a heat transfer sheet 23 comprising expanded graphite (made by Toyo Tanso Co., Ltd graphite sheet "PF-20 D=2.0", width L5 = 60 mm, length L6 = 100 mm, thickness = 0.2 mm, and bulk density 2.0 Mg/m$^3$) is affixed to the stainless steel plate 20a of the stainless steel plates 20a and 20b (i.e., the stainless steel plate on the left side of Fig. 11) by the same silicone grease as used for affixing the stainless steel plates 20a and 20b.

(Comparative Example)

The same configuration as described in the foregoing Example is employed, except that an aluminum plate 22 having the same dimensions as those of the heat transfer sheet 23 (the width, length, and the thickness thereof are identical to those of the heat transfer sheet of the foregoing example) is affixed to a stainless steel plate 20b (the stainless steel plate located on the right in Fig. 11) of the stainless steel plates 20a and 20b shown in Fig. 11.

(Experiment)

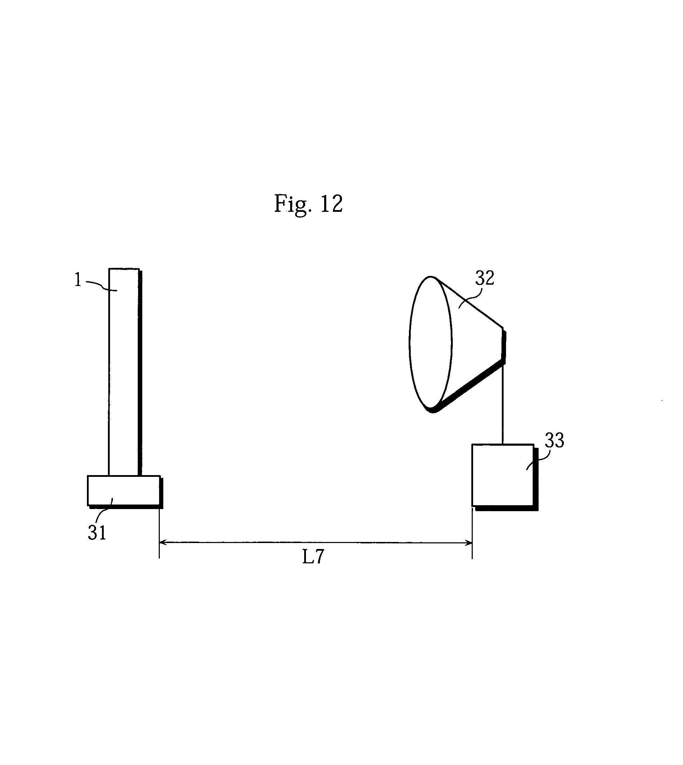

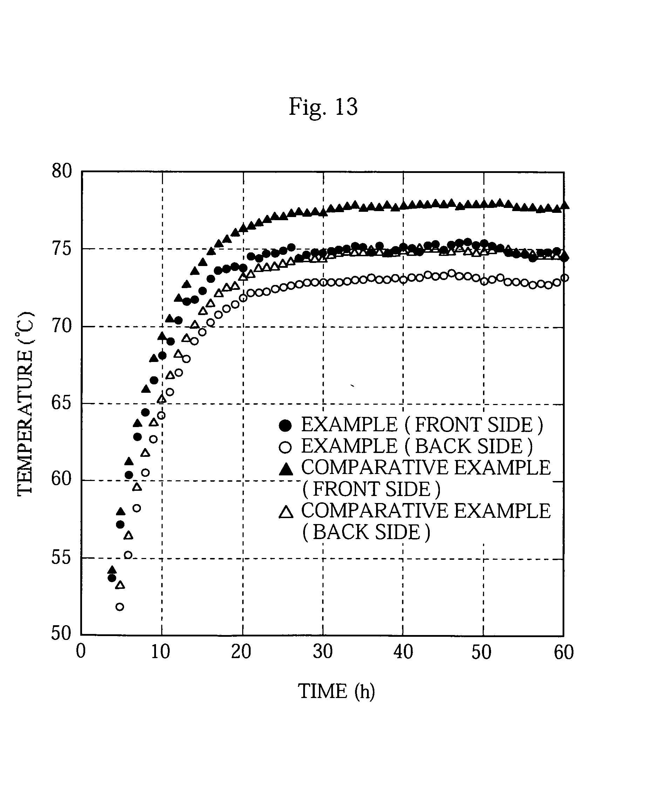

As shown in Fig. 12, the solar battery module 1 to which the thermocouples and so forth were attached was placed on a mounting table 31, and an irradiator means 32 disposed on a mounting table 33 was disposed at a predetermined distance (L7 = 650 mm) away from the solar battery module 1. An incandescent reflector light bulb (rated voltage 100V, rated power consumption 450 W) was used for the light source of the irradiator means 32.
Using the above-described test equipment, light was applied to the front side of the solar battery module 1 to continuously measure the temperatures of the front surfaces and the back surfaces in the portions of the solar battery module 1 that correspond to the Example and the Comparative Example by the thermocouples 18a to 18f. The results are shown in Fig. 13.

As clearly seen from Fig. 13, both the front side and the back side of the Example showed lower temperatures by about 2°C to 3°C than the Comparative Example. This demonstrates that the advantageous effects of the present invention were exhibited significantly.

INDUSTRIAL APPLICABILITY

The present invention can be applied to solar battery units.

BRIEF DESCRIPTION OF THE DRAWINGS

[Fig. 1] Fig. 1 is a perspective view illustrating a solar battery unit according to the present invention.
[Fig. 2] Fig. 2 is a cross-sectional view taken along line A-A in Fig. 1.
[Fig. 3] Fig. 3 is an enlarged cross-sectional view illustrating a portion of a solar battery unit according to the present invention in the vicinity of the interface between a solar battery module, a heat transfer sheet, and a heat dissipating member.
[Fig. 4] Fig. 4 is a cross-sectional view illustrating a modified example of the solar battery unit according to the present invention.
[Fig. 5] Fig. 5 is a cross-sectional view illustrating another modified example of the solar battery unit according to the present invention.
[Fig. 6] Fig. 6 is a cross-sectional view illustrating still another modified example of the solar battery unit according to the present invention.
[Fig. 7] Fig. 7 is a cross-sectional view illustrating yet another modified example of the solar battery unit according to the present invention.
[Fig. 8] Fig. 8 is a cross-sectional view illustrating the solar battery unit according to the present invention in which a clamp is provided.
[Fig. 9] Fig. 9 is a front view of a solar battery module.
[Fig. 10] Fig. 10 is a rear view illustrating the solar battery module on the back surface of which a stainless steel plate is affixed.

[Fig. 11] Fig. 11 is a rear view illustrating the solar battery module in which a heat transfer sheet made of expanded graphite or the like and an aluminum plate are affixed to the stainless steel plate affixed to the back surface thereof.

[Fig. 12] Fig. 12 is a schematic illustrative view illustrating how the experiment is performed.

[Fig. 13] Fig. 13 is a graph illustrating the relationship between time and temperature in the solar battery module of the example and the solar battery module of the comparative example.

[Fig. 14] Fig. 14 is an enlarged cross-sectional view illustrating a portion of a solar battery unit of the background art, in the vicinity of the interface between a solar battery module, a heat transfer sheet, and a heat dissipating member.

DESCRIPTION OF REFERENCE NUMERALS

1    solar battery unit
2    solar battery module
3    heat transfer sheet
4    heat dissipating member (heat dissipating means)

**Claims**

1. A solar battery unit comprising: a solar battery module; and a heat dissipating means, provided on a back surface of the solar battery module, for releasing heat from the solar battery module, the solar battery unit being **characterized in that**:

   a heat transfer sheet comprising expanded graphite is interposed between the solar battery module and the heat dissipating means, and the heat transfer sheet is attached in a compressed state to the solar battery module and the heat dissipating means.

2. The solar battery unit according to claim 1, wherein the heat dissipating means is in a plate shape, and the heat transfer sheet is sandwiched between the heat dissipating means and the back surface of the solar battery module.

3. The solar battery unit according to claim 2, wherein a cooling fin is formed on a surface of the heat dissipating means that is opposite a surface thereof being in contact with the heat transfer sheet.

4. The solar battery unit according to claim 2, wherein a coolant passage for passing coolant is provided in the heat dissipating means.

5. A solar battery unit comprising: a solar battery module; and a heat dissipating means, provided on a back surface of the solar battery module, for releasing heat from the solar battery module, the solar battery unit being **characterized in that**:

   the heat dissipating means comprises a heat transfer sheet comprising expanded graphite, and the heat transfer sheet is attached in a compressed state to the solar battery module.

6. The solar battery unit according to any one of claims 1 through 5, wherein the pressure to the heat transfer sheet is from 0.5 MPa to 10.0 MPa.

7. The solar battery unit according to any one of claims 1 through 6, wherein the heat transfer sheet has a bulk density of $1.0$ Mg/m$^3$ or lower.

8. A solar battery unit comprising: a solar battery module; and a heat dissipating means, provided on a back surface of the solar battery module, for releasing heat from the solar battery module, the solar battery unit being **characterized in that**:

   the heat dissipating means comprises a heat transfer sheet comprising expanded graphite, and the heat transfer sheet is affixed to the solar battery module.

9. The solar battery unit according to claim 8, wherein the heat transfer sheet has a bulk density of from 1.0 Mg/m$^3$ to 2.0 Mg/m$^3$.

10. The solar battery unit according to any one of claims 1 through 9, wherein the heat transfer sheet has a thickness of from 0.1 mm to 3.0 mm.

Fig. 1

Fig. 2

Fig. 3

Fig. 4

Fig. 5

Fig. 6

Fig. 7

Fig. 8

Fig. 9

## Fig. 10

RESISTANCE LOAD
CEMENT RESISTOR
5W · 50Ω

## Fig. 11

RESISTANCE LOAD
CEMENT RESISTOR
5W · 50Ω

Fig. 12

L7

Fig. 13

Fig. 14
Prior Art

## INTERNATIONAL SEARCH REPORT

| International application No. |
|---|
| PCT/JP2008/067400 |

A.   CLASSIFICATION OF SUBJECT MATTER
*H01L31/052*(2006.01)i

According to International Patent Classification (IPC) or to both national classification and IPC

B.   FIELDS SEARCHED

Minimum documentation searched (classification system followed by classification symbols)
H01L31/00-31/20

Documentation searched other than minimum documentation to the extent that such documents are included in the fields searched
Jitsuyo Shinan Koho          1922-1996   Jitsuyo Shinan Toroku Koho   1996-2008
Kokai Jitsuyo Shinan Koho    1971-2008   Toroku Jitsuyo Shinan Koho   1994-2008

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| X | JP 2001-36116 A  (Bridgestone Corp.), 09 February, 2001 (09.02.01), (Family: none) | 1-10 |
| A | US 6005184 A  (Barnes), 21 December, 1999 (21.12.99), (Family: none) | 1-10 |
| A | JP 10-56189 A  (Sekisui Chemical Co., Ltd.), 24 February, 1998 (24.02.98), (Family: none) | 1-10 |
| A | JP 62-281377 A  (Kyocera Corp.), 07 December, 1987 (07.12.87), (Family: none) | 1-10 |

☐ Further documents are listed in the continuation of Box C.       ☐ See patent family annex.

| * | Special categories of cited documents: |
|---|---|
| "A" | document defining the general state of the art which is not considered   to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search 02 December, 2008 (02.12.08) | Date of mailing of the international search report 16 December, 2008 (16.12.08) |
|---|---|
| Name and mailing address of the ISA/ Japanese Patent Office | Authorized officer |
| Facsimile No. | Telephone No. |

Form PCT/ISA/210 (second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H0983003 B

- JP 2000114574 A